# EUROPÄISCHE PATENTSCHRIFT

(11) **EP 2 791 689 B1**
(45) Veröffentlichungstag und Bekanntmachung des Hinweises auf die Patenterteilung: **18.01.2023**
(21) Anmeldenummer: 12787716.5
(22) Anmeldetag: 15.11.2012
(51) Int. Cl.: G01R 1/20, G01R 15/20

(54) **STROMMESSSCHALTUNG, BATTERIE UND KRAFTFAHRZEUG**
CURRENT MEASURING CIRCUIT, BATTERY AND MOTOR VEHICLE
CIRCUIT DE MESURE DE COURANT, BATTERIE ET VÉHICULE À MOTEUR

(30) Priorität: 16.12.2011 DE 102011088893
(43) Veröffentlichungstag der Anmeldung: 22.10.2014
(73) Patentinhaber: Robert Bosch GmbH, 70442 Stuttgart (DE); Samsung SDI Co., Ltd., Yongin-si Gyeonggi-do 446-577 (KR)
(72) Erfinder: KAUPP, Patrick, 70195 Stuttgart (DE)
(74) Vertreter: Bee, Joachim
(86) Internationale Anmeldenummer: PCT/EP2012/072713
(87) Internationale Veröffentlichungsnummer: WO 2013/087342

(56) Entgegenhaltungen:
- EP-A1- 1 213 189
- DE-A1-102009 046 564

## Beschreibung

Die vorliegende Erfindung betrifft eine Strommessschaltung zur redundanten Messung elektrischen Stroms mit einem Messwiderstand, einer Auswerteschaltung auf einer Auswerteschaltungsplatine und einem Magnetfeldsensor.

Ferner betrifft die Erfindung eine Batterie mit der erfindungsgemäßen Strommessschaltung sowie ein Kraftfahrzeug mit der erfindungsgemäßen Batterie.

### Stand der Technik

Es zeichnet sich ab, dass in Zukunft sowohl bei stationären Anwendungen, wie Windkraftanlagen, in Kraftfahrzeugen, die als Hybrid- oder Elektrokraftfahrzeuge ausgelegt sind, als auch bei Elektronikgeräten, wie Laptops oder Mobiltelefonen, neue Batteriesysteme zum Einsatz kommen werden, an die sehr hohe Anforderungen bezüglich Zuverlässigkeit, Sicherheit, Leistungsfähigkeit und Lebensdauer gestellt werden.

In Fahrzeugen mit zumindest teilweisem elektrischen Antrieb kommen elektrische Energiespeicher zum Einsatz, um die elektrische Energie für den Elektromotor, welcher den Antrieb unterstützt bzw. als Antrieb dient, zu speichern. In den Fahrzeugen der neuesten Generation finden hierbei sogenannte Lithium-Ionen-Batterien Verwendung. Diese zeichnen sich unter anderem durch hohe Energiedichten und eine äußerst geringe Selbstentladung aus. Lithium-Ionen-Zellen besitzen mindestens eine positive und eine negative Elektrode (Kathode bzw. Anode), die Lithium-Ionen (Li+) reversibel ein-(Interkalation) oder wieder auslagern (Deinterkalation) können.

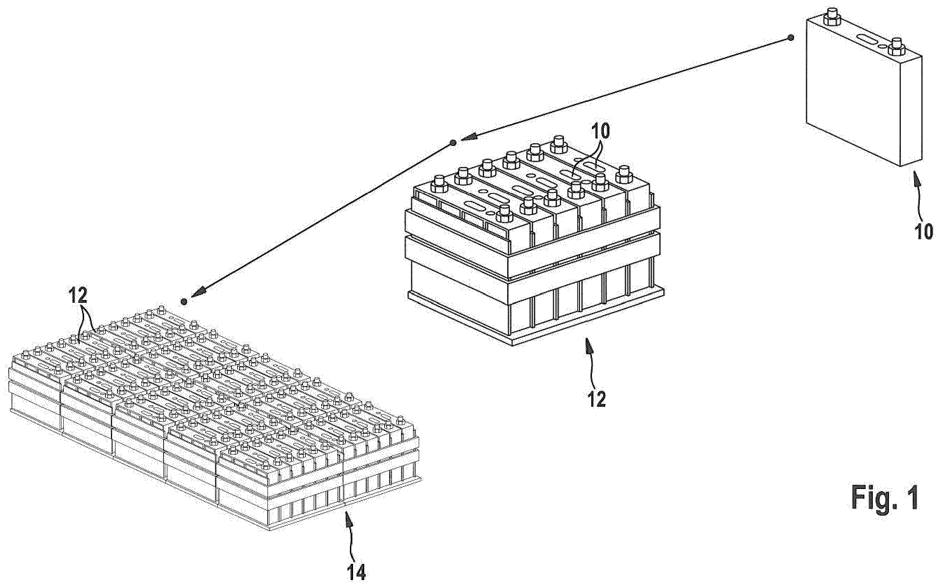

Figur 1 zeigt, wie einzelne Batteriezellen 10 zu Batteriemodulen 12 und dann zu Batterien 14 zusammengefasst werden können. Dies erfolgt durch eine nicht dargestellte Parallel- oder Reihenschaltung der Pole der Batteriezellen 10. Dabei besteht per Definition ein Batteriemodul 12 bzw. eine Batterie 14 aus mindestens zwei Batteriezellen 10, wobei die Begriffe Batterie 14 und Batteriemodul 12 oft synonym verwendet werden. Die elektrische Spannung einer Batterie 14 beträgt beispielsweise zwischen 120 und 600 Volt Gleichstrom.

Bei Batterien für automobile Antriebstechniken (Traktionsbatterien) besteht die Notwendigkeit, zur Bestimmung des Ladezustands und aus Sicherheitsgründen, den zu- und abgeführten Strom der Batteriezellen zu messen. Deshalb muss die Funktionsfähigkeit des Stromsensors bekannt und daher durch geeignete Maßnahmen detektierbar sein. In vielen Fällen erfolgt die Erfassung des Stroms mit Hilfe von Stromsensoren, die nach dem Widerstandsprinzip arbeiten (Shunt). Um die Verlustleistung im Shunt-Widerstand klein zu halten, ist dessen Widerstandswert viel kleiner als der des Verbrauchers gewählt. Die sich dadurch ergebenden kleinen Spannungsabfälle müssen daher zur Auswertung mit Hilfe nachgeschalteter elektronischer Schaltungen verstärkt und ausgewertet werden. Ist die Verbindung zwischen Widerstand und Auswerteschaltung unterbrochen oder weist der Widerstand oder die Schaltung einen anderen Defekt auf, kann dies nicht ohne weiteres eindeutig festgestellt werden.

Die DE 10 2009 046 564 A1 offenbart ein Batteriesystem mit einem Hochspannungsnetz und einem Niederspannungsnetz. Das Hochspannungsnetz umfasst ein Batteriemodul, während das Niederspannungsnetz eine Battery Control Unit (BCU) umfasst. Zellüberwachungseinheiten sind den Batteriezellen zugeordnet und messen die Spannungen der Batteriezellen. Des Weiteren offenbart die Druckschrift eine redundante Strommessung mittels eines Messwiderstandes (Shunt) und eines Hall-Sensors.

### Offenbarung der Erfindung

Erfindungsgemäß wird eine Strommessschaltung zur redundanten Messung elektrischen Stroms mit einem Messwiderstand gemäss dem Anspruch 1 zur Verfügung gestellt.

Der Erfindung liegt die Erkenntnis zugrunde, durch Integration des Magnetfeldsensors auf der Auswerteschaltungsplatine, beispielsweise im Rahmen einer Bestückoption, eine besonders kompakte sowie kostengünstige redundante Strommessschaltung in einer Einheit zu ermöglichen, welche auf zwei unterschiedlichen Messprinzipien beruht. Dies wird ermöglicht, indem der Magnetfeldsensor jenes Magnetfeld erfasst, welches sich durch den Stromfluss im Messwiderstand um den Messwiderstand herum aufbaut.

Bei der Wahl des Messwiderstandes empfiehlt sich die Verwendung eines möglichst kleinen Messwiderstandes - auch Shunt genannt. Vorzugsweise kommen Messwiderstände mit einem elektrischen Widerstand kleiner 1 mΩ in Frage, um die durch den Messwiderstand verursachten Verluste klein zu halten. Durch die Verwendung eines kleinen Messwiderstands können an diesem im Betrieb jedoch auch nur kleine Spannungsabfälle gemessen werden. Diese kleinen Spannungsabfälle werden wie üblich mit Hilfe der Auswerteschaltung verstärkt und ausgewertet und dienen als Maß für den im Messwiderstand fließenden Strom. Aufgrund der relativ hohen Genauigkeit solcher Schaltungen dient das daraus gewonnene Signal als primäres Signal zur genauen Bestimmung des durch den Messwiderstand fließenden Stroms.

Der Magnetfeldsensor ist auf der Auswerteschaltungsplatine zusätzlich zur Auswerteschaltung angeordnet und ist dazu ausgebildet, ein dem Stromfluss proportionales Magnetfeld um den Messwiderstand zu messen - bevorzugt ist der Magnetfeldsensor als Hall-Sensor ausgeführt. Das vom Magnetfeldsensor ausgegebene sekundäre Signal entspricht wiederum dem durch den Messwiderstand fließenden Strom, welcher so über ein zweites unabhängiges Messprinzip redundant ermittelt wird.

Gemäß einer vorteilhaften Ausgestaltung der Erfindung ist die Auswerteschaltung ferner dazu ausgebildet, das primäre Signal entsprechend dem mittels des Messwiderstands bestimmten Strom mit dem sekundären Signal entsprechend dem mittels des Magnetfeldsensors bestimmten Strom zu vergleichen und bei einer Abweichung der beiden Signale ein Fehlersignal auszugeben. Dies kann durch die Integration weniger zusätzlicher Bauteile, beispielsweise von Auswertungsbausteinen auf der Auswerteschaltungsplatine, erreicht werden. Das primäre Signal, welches über den Messwiderstand und die Auswerteschaltung bestimmt wird, lässt in der Regel genauere Schlüsse auf den Stromfluss zu als das sekundäre Signal des Magnetfeldsensors. Sollte das primäre Signal jedoch plötzlich signifikant von dem sekundären Signal des Magnetfeldsensors abweichen, so wird das Fehlersignal ausgegeben, wodurch ein Fehler in der Strommessschaltung erkannt werden kann.

Damit der Magnetfeldsensor optimal betrieben werden kann, ist dieser in unmittelbarer Nähe zum Messwiderstand angeordnet. Bevorzugt beträgt der Normalabstand zwischen dem Magnetfeldsensor und dem Messwiderstand weniger als 10 mm, insbesondere kleiner-gleich (≤) 5 mm. Je kleiner der Normalabstand, desto besser ist die Störunempfindlichkeit gegenüber äußeren magnetischen Störfeldern.

Ferner bevorzugt liegt die Auswerteschaltungsplatine mit dem Magnetfeldsensor flächig auf dem Messwiderstand auf. In diesem Fall kann es erforderlich sein, die Auswerteschaltungsplatine bis auf zwei elektrisch leitfähige Verbindungen zu dem Messwiderstand von diesem elektrisch zu isolieren. Durch die zwei elektrisch leitfähigen Verbindungen mit dem Messwiderstand kann der Spannungsabfall am Messwiderstand gemessen werden kann.

Ferner wird eine Batterie mit einer Strommessschaltung zur Verfügung gestellt. Die Strommessschaltung dient beispielsweise zur Messung von Strömen innerhalb der Batterie.

Vorzugsweise ist die Batterie eine Lithium-Ionen-Batterie. Durch die Verwendung der Lithium-Ionen-Technologie mittels einer Mehrzahl an Lithium-Ionen-Sekundärzellen können besonders hohe Energiespeicherdichten erzielt werden, was besonders im Bereich der Elektromobilität zu weiteren Vorteilen führt.

Des Weiteren wird ein Kraftfahrzeug mit der erfindungsgemäßen Batterie zur Verfügung gestellt. Die Batterie dient in der Regel zur Energieversorgung des Antriebes des Kraftfahrzeugs. Die erfindungsgemäße Batterie kann auch vorteilhaft in einem elektrischen Gerät verwendet werden.

Vorteilhafte Weiterbildungen der Erfindung sind in den Unteransprüchen angegeben und können der Beschreibung entnommen werden.

### Zeichnungen

Ausführungsbeispiele der Erfindung werden anhand der Zeichnungen und der nachfolgenden Beschreibung näher erläutert. Es zeigen:
Figur 1 eine Batteriezelle, ein Modul und eine Batterie, und
Figur 2 eine erfindungsgemäße Strommessschaltung.

Auf Figur 1 wurde bereits zur Erläuterung des Standes der Technik eingegangen.

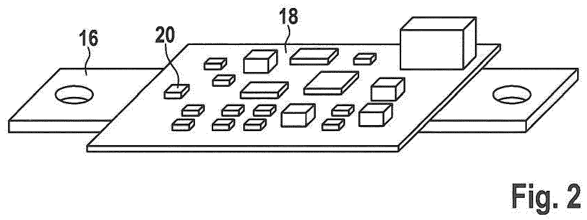

Figur 2 zeigt eine erfindungsgemäße Strommessschaltung mit einem Messwiderstand 16 mit Anschlüssen, welche in der Figur links und rechts abgebildet sind. Auf der Auswerteschaltungsplatine 18 ist neben den Bauteilen der Auswerteschaltung auch ein Magnetfeldsensor 20, beispielsweise ein Hall-Sensor angeordnet. Um eine möglichst kompakte Anordnung und für den Magnetfeldsensor 20 optimale Betriebsbedingungen zu schaffen, kann die Auswerteschaltungsplatine 18 flächig auf dem Messwiderstand 16 aufliegen. Zur elektrischen Isolation der Auswerteschaltungsplatine 18 von dem Messwiderstand 16 kann dann zwischen beiden ein elektrischer Isolator angeordnet sein, jedoch ist die Auswerteschaltung über zwei nicht dargestellte, elektrisch leitfähige Verbindungen mit dem Messwiderstand 16 verbunden.

Über diese zwei elektrisch leitfähigen Verbindungen kann die Auswerteschaltung einen Spannungsabfall am Messwiderstand 16 messen, wenn der Messwiderstand 16 von einem elektrischen Strom durchflossen wird. Die Auswerteschaltung verstärkt dieses Signal, welches als primäres Signal zur genauen Bestimmung des elektrischen Stromes dient.

Auf der Auswerteschaltungsplatine 18 ist ein Magnetfeldsensor 20 angeordnet, welcher zur redundanten Messung des durch den Messwiderstand 16 fließenden Stroms mittels eines unabhängigen Messprinzips dient. Dieser erfasst das Magnetfeld des Messwiderstands 16, welches dem Stromfluss durch den Messwiderstand 16 proportional ist und liefert ein sekundäres Signal zur Bestimmung des elektrischen Stroms.

Die Auswerteschaltung kann zusätzlich zu ihrer Funktion der Verstärkung des gemessenen Spannungsabfalls am Messwiderstand 16 dazu eingerichtet sein, das sekundäre Signal des Magnetfeldsensors 20 mit dem primären Signal des Messwiderstands 16 zu vergleichen. Bei Abweichungen des primären Signals vom sekundären Signal wird ein Fehlersignal ausgegeben, wodurch auf eine Fehlfunktion der Strommessschaltung geschlossen werden kann.

## Patentansprüche

1. Strommessschaltung zur redundanten Messung elektrischen Stroms mit einem Messwiderstand (16), einem Magnetfeldsensor (20) und einer Auswerteschaltung auf einer Auswerteschaltungsplatine (18) zur Bestimmung des elektrischen Stroms mit Hilfe des Messwiderstands (16), **dadurch gekennzeichnet, dass** der Magnetfeldsensor (20) auf der Auswerteschaltungsplatine (18) und die Auswerteschaltungsplatine (18) in unmittelbarer Nähe des Messwiderstands (16) angeordnet sind, so dass der Magnetfeldsensor (20) das Magnetfeld des stromdurchflossenen Messwiderstands (16) erfassen kann,
wobei der Magnetfeldsensor dazu ausgebildet ist, ein dem Stromfluss proportionales Magnetfeld um den Messwiderstand zu messen.

2. Strommessschaltung nach Anspruch 1, wobei die Auswerteschaltung ferner dazu ausgebildet ist, ein primäres Signal entsprechend dem mittels des Messwiderstands (16) bestimmten Strom mit einem sekundären Signal entsprechend dem mittels des Magnetfeldsensors (20) bestimmten Strom zu vergleichen und bei einer Abweichung der beiden Signale ein Fehlersignal auszugeben.

3. Strommessschaltung nach einem der vorhergehenden Ansprüche, wobei der Normalabstand zwischen dem Magnetfeldsensor (20) und dem Messwiderstand (16) weniger als 10 mm beträgt.

4. Strommessschaltung nach Anspruch 3, wobei der Normalabstand zwischen dem Magnetfeldsensor (20) und dem Messwiderstand (16) kleiner gleich 5 mm beträgt.

5. Strommessschaltung nach einem der vorhergehenden Ansprüche, wobei die Auswerteschaltungsplatine (18) mit dem Magnetfeldsensor (20) flächig auf dem Messwiderstand (16) aufliegt.

6. Strommessschaltung nach einem der vorhergehenden Ansprüche, wobei der Messwiderstand (16) einen elektrischen Widerstand kleiner 1 mΩ aufweist.

7. Strommessschaltung nach einem der vorhergehenden Ansprüche, wobei der Magnetfeldsensor (20) ein Hall-Sensor ist.

8. Batterie (14) mit einer Strommessschaltung nach einem der Ansprüche 1 bis 7.

9. Batterie (14) nach Anspruch 8, wobei die Batterie (14) eine Lithium-Ionen-Batterie ist.

10. Kraftfahrzeug oder elektrisches Gerät mit einer Batterie (14) nach einem der Ansprüche 8 bis 9.

## Claims

1. Current-measuring circuit for redundantly measuring an electric current, having a measuring resistor (16), a magnetic-field sensor (20) and an evaluation circuit on an evaluation-circuit printed circuit board (18) for determining the electric current using the measuring resistor (16), **characterized in that** the magnetic-field sensor (20) on the evaluation-circuit printed circuit board (18) and the evaluation-circuit printed circuit board (18) are arranged in the immediate vicinity of the measuring resistor (16), with the result that the magnetic-field sensor (20) can detect the magnetic field of the measuring resistor (16) when current flows through it,
wherein the magnetic-field sensor is designed to measure a magnetic field around the measuring resistor, which magnetic field is proportional to the flow of current.

2. Current-measuring circuit according Claim 1, wherein the evaluation circuit is also designed to compare a primary signal corresponding to the current determined by means of the measuring resistor (16) with a secondary signal corresponding to the current determined by means of the magnetic-field sensor (20) and to output an error signal in the event that the two signals differ.

3. Current-measuring circuit according to either of the preceding claims, wherein the normal distance between the magnetic-field sensor (20) and the measuring resistor (16) is less than 10 mm.

4. Current-measuring circuit according to Claim 3, wherein the normal distance between the magnetic-field sensor (20) and the measuring resistor (16) is less than or equal to 5 mm.

5. Current-measuring circuit according to one of the preceding claims, wherein the evaluation-circuit printed circuit board (18) having the magnetic-field sensor (20) lies flat against the measuring resistor (16).

6. Current-measuring circuit according to one of the preceding claims, wherein the measuring resistor (16) has an electrical resistance of less than 1 mΩ.

7. Current-measuring circuit according to one of the preceding claims, wherein the magnetic-field sensor (20) is a Hall sensor.

8. Battery (14) having a current-measuring circuit according to one of Claims 1 to 7.

9. Battery (14) according to Claim 8, wherein the battery (14) is a lithium-ion battery.

10. Motor vehicle or electrical device having a battery (14) according to one of Claims 8 and 9.

## Revendications

1. Circuit de mesure de courant pour la mesure redondante d'un courant électrique, comprenant une résistance de mesure (16), un capteur de champ magnétique (20) et un circuit d'évaluation sur une platine de circuit d'évaluation (18) pour déterminer le courant électrique à l'aide de la résistance de mesure (16),
**caractérisé en ce que** le capteur de champ magnétique (20) est disposé sur la platine de circuit d'évaluation (18) et la platine de circuit d'évaluation (18) est disposée à proximité immédiate de la résistance de mesure (16) de sorte que le capteur de champ magnétique (20) peut détecter le champ magnétique de la résistance de mesure (16) parcourue par le courant,
dans lequel le capteur de champ magnétique est réalisé pour mesurer un champ magnétique proportionnel au flux de courant afin de mesurer la résistance de mesure.

2. Circuit de mesure de courant selon la revendication 1, dans lequel le circuit d'évaluation est en outre réalisé pour comparer un signal primaire correspondant au courant déterminé au moyen de la résistance de mesure (16) avec un signal secondaire correspondant au courant déterminé au moyen du capteur de champ magnétique (20), et pour sortir un signal d'erreur en cas de divergence entre les deux signaux.

3. Circuit de mesure de courant selon l'une quelconque des revendications précédentes, dans lequel la distance normale entre le capteur de champ magnétique (20) et la résistance de mesure (16) est inférieure à 10 mm.

4. Circuit de mesure de courant selon la revendication 3, dans lequel la distance normale entre le capteur de champ magnétique (20) et la résistance de mesure (16) est inférieure ou égale à 5 mm.

5. Circuit de mesure de courant selon l'une quelconque des revendications précédentes, dans lequel la platine de circuit d'évaluation (18) avec le capteur de champ magnétique (20) repose de manière plane sur la résistance de mesure (16).

6. Circuit de mesure de courant selon l'une quelconque des revendications précédentes, dans lequel la résistance de mesure (16) présente une résistance électrique inférieure à 1 mΩ.

7. Circuit de mesure de courant selon l'une quelconque des revendications précédentes, dans lequel le capteur de champ magnétique (20) est un capteur à effet Hall.

8. Batterie (14) comprenant un circuit de mesure de courant selon l'une quelconque des revendications 1 à 7.

9. Batterie (14) selon la revendication 8, dans lequel la batterie (14) est une batterie lithium-ion.

10. Véhicule automobile ou appareil électrique comprenant une batterie (14) selon l'une quelconque des revendications 8 à 9.
